# EUROPÄISCHE PATENTSCHRIFT

(11) **EP 2 174 338 B1**
(45) Veröffentlichungstag und Bekanntmachung des Hinweises auf die Patenterteilung: **30.05.2012**
(21) Anmeldenummer: 08784945.1
(22) Anmeldetag: 22.07.2008
(51) Int. Cl.: H01J 37/32

(54) **VERFAHREN ZUM BETRIEB EINER PLASMAVERSORGUNGSEINRICHTUNG UND PLASMAVERSORGUNGSEINRICHTUNG**
METHOD FOR OPERATION OF A PLASMA SUPPLY DEVICE AND A PLASMA SUPPLY DEVICE
PROCÉDÉ D'UTILISATION D'UN DISPOSITIF D'ALIMENTATION EN PLASMA ET DISPOSITIF D'ALIMENTATION EN PLASMA

(30) Priorität: 23.07.2007 US 951392 P
(43) Veröffentlichungstag der Anmeldung: 14.04.2010
(73) Patentinhaber: HÜTTINGER Elektronik GmbH + Co. KG, 79111 Freiburg (DE)
(72) Erfinder: KIRCHMEIER, Thomas, 79331 Teningen (DE); KNAUS, Hanns-Joachim, 79312 Emmendingen (DE); GLÜCK, Michael, 79111 Freiburg (DE); WINDISCH, Hans-Jürgen, 79238 Ehrenkirchen (DE)
(74) Vertreter: Kohler Schmid Möbus
(86) Internationale Anmeldenummer: PCT/EP2008/005980
(87) Internationale Veröffentlichungsnummer: WO 2009/012966

(56) Entgegenhaltungen:
- WO-A-98/57406
- WO-A-2005/094138

## Beschreibung

Die Erfindung betrifft ein Verfahren zum Betrieb einer Plasmaversorgungseinrichtung mit zumindest einer wenigstens zwei schaltende Elemente aufweisenden Schaltbrücke, wobei die Plasmaversorgungseinrichtung, ein Hochfrequenzausgangssignal mit einer Leistung > 500 W und einer im Wesentlichen konstanten Grundfrequenz > 3 MHz an eine Plasmalast liefert.

Außerdem betrifft die Erfindung eine Plasmaversorgungseinrichtung.

Bei einem Plasma handelt es sich um einen besonderen Aggregatzustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch Zufuhr von Energie die Atome bzw. Moleküle in positive und negative Ladungsträger, also in Ionen und Elektronen, aufgespaltet werden. Ein Plasma eignet sich zur Bearbeitung von Werkstücken, da die elektrisch geladenen Teilchen chemisch hochgradig reaktiv und zudem durch elektrische Felder beeinflussbar sind. Die geladenen Teilchen können mittels eines elektrischen Feldes auf ein Werkstück beschleunigt werden, wo sie beim Aufprall einzelne Atome aus dem Werkstück herauslösen können. Die herausgelösten Atome können über Gasfluss abtransportiert werden (Ätzen) oder auf anderen Werkstücken als Beschichtung abgelagert werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz, Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität. Weiterhin kann ein Plasma auch zur Anregung von Lasern, insbesondere Gaslasern, dienen.

Um aus einem Gas ein Plasma zu generieren, muss ihm Energie zugeführt werden. Das kann auf unterschiedliche Weise, beispielsweise über Licht, Wärme, elektrische Energie, erfolgen. Ein Plasma zur Bearbeitung von Werkstücken wird typischerweise in einer Plasmakammer gezündet und aufrecht erhalten. Dazu wird in der Regel ein Edelgas, z. B. Argon, mit niedrigem Druck in die Plasmakammer geleitet. Über Elektroden und/oder Antennen wird das Gas einem elektrischen Feld ausgesetzt. Ein Plasma entsteht bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirken die Entladungen bei der Kollision dieser Teilchen mit der Wand der Plasmakammer oder anderen Gegenständen sowie die natürliche Rekombination entgegen, d. h., Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Die Energiezufuhr kann über eine Gleichstrom-Versorgungseinrichtung oder eine Wechselstrom-Versorgungseinrichtung erfolgen. Die folgenden Ausführungen beziehen sich auf Wechselstrom-Versorgungseinrichtungen für Hochfrequenz (HF) mit einer Ausgangsfrequenz von > 3 MHz.

Plasmen haben eine sehr dynamische Impedanz, die die gewünschte gleichmäßige HF-Leistungsversorgung schwierig macht. So wechselt während des Zündvorgangs die Impedanz von einem hohen Wert sehr schnell zu einem niedrigen Wert, während des Betriebes können negative Wirkwiderstände vorkommen, die bei steigender Spannung den Stromfluss vermindern, und es kann zu unerwünschten lokalen Entladungen (Arcs) kommen, die das zu bearbeitende Gut, die Plasmakammer oder die Elektroden schädigen können.

Daher müssen Versorgungseinrichtungen für Plasmen (Plasmaversorgungseinrichtungen) für eine hohe Ausgangsleistung und eine hohe reflektierte Leistung ausgelegt sein. EP 1 701 376 A1 hat gezeigt, dass sich derartige Plasmaversorgungseinrichtungen vorteilhaft durch kleinere Hochfrequenzverstärker realisieren lassen, deren Ausgangsleistungen durch einen Koppler, vorzugsweise durch einen 3-dB-Hybridkoppler (hybrid coupler, Lange coupler) gekoppelt werden. Dazu werden die zwei Hochfrequenzverstärker an zwei Tore (ports) des Hybridkopplers, im Folgenden Tor 1 und Tor 2 genannt, angeschlossen. Die Hochfrequenzverstärker werden so angesteuert, dass ihre Hochfrequenzsignale gleicher Grundfrequenz eine Phasenverschiebung von 90° zueinander haben. An einem dritten Tor des Hybridkopplers liegt das erste der beiden Hochfrequenzsignale um 45° nachlaufend und das zweite um 45° voreilend an. An einem vierten Tor des Hybridkopplers liegt das erste der beiden Hochfrequenzsignale um 45° voreilend und das zweite um 45° nachlaufend an. Durch Phasenverschiebung der beiden erzeugten Hochfrequenzsignale um 90° addieren sich diese am dritten Tor durch konstruktive Überlagerung (constructive superposition), während sie sich am vierten Tor auslöschen (destructive superposition). Somit benötigen die Hochfrequenzverstärker vor dem Koppler jeweils nur die halbe Leistung des erforderlichen Hochfrequenzausgangssignals. Eine Kaskadierung von derartigen Kopplerstufen ist möglich, um Hochfrequenzverstärker mit noch weniger Ursprungsleistung einsetzen zu können oder eine noch höhere Leistung des Hochfrequenzausgangssignals zu erzielen.

Das vierte Tor des Hybridkopplers wird üblicherweise mit einem Abschlusswiderstand der Systemnennimpedanz (oftmals 50 Ω) abgeschlossen. Wie in EP 1 701 376 A1 beschrieben, wird an diesem Tor nur dann ein Hochfrequenzsignal erwartet, wenn ein von der Plasmalast reflektiertes Hochfrequenzsignal wiederum an den Hochfrequenzverstärkern reflektiert wird.

Bei Fehlanpassung infolge unterschiedlicher Impedanzen von Plasmaversorgungseinrichtung und Plasmalast kommt es zur teilweisen oder vollständigen Reflexion der von der Plasmaversorgungseinrichtung gelieferten Leistung. Eine Impedanzanpassschaltung (matchbox) kann in bestimmten Bereichen die Impedanz der Plasmalast transformieren und der Ausgangsimpedanz der Plasmaversorgungseinrichtung anpassen. Wird der Transformationsbereich der Anpassschaltung überschritten oder kann die Regelung der Impedanzanpassschaltung einer schnellen Impedanzänderung des Plasmas nicht folgen, so wird nicht die gesamte von der Plasmaversorgungseinrichtung gelieferte Leistung in dem Plasma absorbiert, sondern es findet wieder Reflexion statt.

Ein von der Plasmalast reflektiertes Hochfrequenzsignal läuft über eine eventuell vorhandene Anpassschaltung zurück zum Tor 3 des Hybridkopplers, wird hier in zwei Teile aufgespalten und über die Tore 1 und 2 in Richtung der Hochfrequenzverstärker der Plasmaversorgungseinrichtung zurückgesendet. Dabei erfahren die beiden Teile des reflektierten Hochfrequenzsignals im Hybridkoppler wieder eine gleiche Phasenverzögerung um 45° beim Weg von Tor 3 nach Tor 1 bzw. einen gleichen Phasenvorlauf um 45° beim Weg von Tor 3 nach Tor 2. Das hat zur Folge, dass sich an beiden Ausgängen der beiden Hochfrequenzverstärker die hinlaufenden und reflektierten Hochfrequenzsignale um 180° verschieden überlagern. Findet beispielsweise am Ausgang des ersten Hochfrequenzverstärkers eine maximal konstruktive Überlagerung von hinlaufendem und reflektiertem Hochfrequenzsignal statt, so wird diese Überlagerung am Ausgang des zweiten Hochfrequenzverstärkers maximal destruktiv sein. Ist die Überlagerung am ersten Hochfrequenzverstärker so, dass das Strommaximum dem Spannungsmaximum in der Zeit vorauseilt, der Hochfrequenzverstärker also eine kapazitive Impedanz als Lastimpedanz sieht, so wird am zweiten Hochfrequenzverstärker das Spannungsmaximum dem Strommaximum in der Zeit vorauseilen, dieser sieht also eine induktive Lastimpedanz.

Eine Schaltungsvariante von Hochfrequenzverstärkern in Plasmastromversorgungen ist ein Klasse-D-Verstärker mit einer Schaltbrücke. Eine Schaltbrücke weist zumindest zwei schaltende Elemente, wie z. B. MOSFETs, auf, die in Serie geschaltet sind; der Verbindungspunkt der schaltenden Elemente stellt den Mittelpunkt der Schaltbrücke dar. Der Mittelpunkt des Brückenzweiges wird durch die zwei Schaltelemente (im Folgenden auch als schaltende Elemente oder Schalter bezeichnet) abwechselnd an den positiven oder negativen Pol einer Leistungsgleichstromversorgung geschaltet. Die abwechselnde Steuerung der beiden Schaltelemente sowie der Schaltelemente eines eventuell vorhandenen zweiten Brückenzweigs erfolgt durch den Ansteuersignalgenerator, der einen Oszillator, der die Frequenz des Ausgangssignals bestimmt, und weitere Bauelemente wie Inverter, Phasenschieber und Signalformer enthalten kann. Eine Schaltbrücke mit zwei schaltenden Elementen wird auch Halbbrücke genannt.

Eine Vollbrückenschaltung besteht aus zwei Brückenzweigen (Halbbrücken), deren Mittelpunkte mit der gewünschten Frequenz jeweils gegensinnig an den positiven und negativen Pol der Gleichspannungsversorgung geschaltet werden. Die Wechselstromlast wird zwischen diesen beiden Mittelpunkten angeordnet. Ein zusätzlicher Kondensator zur Befreiung des Ausgangssignals von einem Gleichspannungsanteil ist nicht notwendig. Eine Vollbrücke(nschaltung) ist demnach eine Schaltbrücke mit vier schaltenden Elementen.

Um Schaltverluste zu vermeiden, sollte es zum Zeitpunkt des Einschaltens der einzelnen Schaltelemente einer Vollbrücke keine nennenswerte Spannungsdifferenz zwischen den beiden Leistungselektroden (im allgemeinen Drain und Source des jeweiligen MOSFETs) geben. Dieses Schaltverhalten wird als Null-Volt-Schalten bezeichnet. Man erreicht dies, indem die Schaltbrücke auf eine Lastimpedanz mit induktivem Charakter arbeitet. Dies bedeutet, dass die Schaltbrücke, eine induktiv absorptive Lastimpedanz sieht. Die Selbstinduktion einer Primärwicklung eines Leistungsübertragers, welche an den Mittelpunkt der Schaltbrücke angeschlossen ist, kann dafür ausgenutzt werden. Bei der zunächst einseitigen Unterbrechung des Stromflusses durch die Primärwicklung wird eine Spannung induziert. Bei geeigneter Dimensionierung der Bauelemente und Berücksichtigung ihrer parasitären Eigenschaften sowie bei richtiger Wahl der Schalt-/Wartezeit ist das Potential an diesem augenblicklich nicht mit der Leistungsgleichstromversorgung verbundenen Ende der Primärwicklung genauso hoch wie das Potential an demjenigen Anschluss der Gleichspannungsquelle, der nun mit dieser Halbbrücke diesem Ende der Primärwicklung zugeschaltet werden soll.

Dagegen ist eine Lastimpedanz mit kapazitivem Charakter (die Schaltbrücke sieht eine kapazitiv absorptive Lastimpedanz) für die Schaltbrücke ungünstig, da der Mittelpunkt beim Vorgang des Umschaltens sein vorheriges Potential behält und damit am nun einschaltenden Element eine Spannungsdifferenz bis hin zur Spannung der Leistungsgleichstromversorgung anliegt. Außerdem können Stromstöße beim Schalten des zweiten schaltenden Elements einer Schaltbrücke in Zusammenwirkung mit parasitären Kapazitäten entstehen.

Wenn die Ausgangssignale zweier Schaltbrücken über einen Koppler gekoppelt werden, kann es unter bestimmten Reflexionsbedingungen sogar vorkommen, dass eine der Schaltbrücken, insbesondere eine Halbbrücke, der anderen Schaltbrücke, insbesondere Halbbrücke, Leistung zuführt. Die Lastimpedanz, die diese Schaltbrücke, der Leistung zugeführt wird, sieht, hat einen negativen Wirkwiderstand. Damit wird die Ausgangsleistung dieser Schaltbrücke negativ. Die Schaltbrücke wird quasi "gefüttert". Dies bedeutet, dass die "gefütterte" Schaltbrücke eine emissive Lastimpedanz, die reell, induktiv oder kapazitiv sein kann, sieht.

In Abhängigkeit der Betriebszustände und der Spezifikationen der Bauteile der Schaltbrücke, also wie nahe diese mit der Versorgungsspannung an der Spezifikationsgrenze betrieben werden, wie gut gekühlt wird, wie schnell der Normalbetrieb (Schaltbetrieb) der schaltenden Elemente der Schaltbrücke beendet werden kann, wie gut Null-Volt-Schalten realisiert werden muss, ergibt sich ein zulässiger Betriebsbereich. Wenn also die Lastimpedanz in einem von den Bauteilspezifikationen und Betriebszuständen der Schaltbrücken abhängigen Betriebsbereich liegt, können die Schaltbrücken betrieben werden, ohne dass eine Beschädigung oder Zerstörung zu befürchten ist. Dabei können sogar gewisse emissive Lastimpedanzen zulässig sein. Lastimpedanzen außerhalb des zulässigen Lastimpedanzbereichs sollten vermieden werden.

Aus der US 6,885,567 B2 ist eine Stromversorgung mit einem Inverter bekannt, der an eine Gleichspannungsversorgung angeschlossen ist. Der Inverter umfasst zwei Halbbrücken. Dieser Inverter ist durch eine Signalquelle angesteuert. Die Phase der Ansteuersignale, die durch die Signalgeneratoren generiert werden, wird eingestellt. Die Ansteuersignale sind somit nicht vollständig unabhängig voneinander.

In der US 7,173,467 B2 ist eine Vollbrücke beschrieben, wobei die schaltenden Elemente der Schaltbrücke mit phasenverschobenen Ansteuersignalen angesteuert werden. Dadurch kann eine Leistungsregelung erfolgen.

Aus der US 2005/0219875 A1 ist eine Steuereinrichtung für eine Schaltstromversorgung bekannt, die auf eine Spannungsüberhöhurig in der Schaltstromversorgung reagiert, um deren Betriebspunkt in einen sicheren Zustand zu bringen. Die Steuereinrichtung detektiert sowohl die Richtung als auch den Betrag des Laststroms in der Schaltstromversorgung und verwendet diese Information, um die schaltenden Elemente der Schaltstromversorgung anzusteuern.

Nachteilig bei den bekannten Lösungen ist, dass die schaltenden Elemente der Halbbrücken häufig einfach nur komplementär, d. h. abwechselnd angesteuert werden. Gegebenenfalls wird zwischen dem wechselseitigen Ansteuern eine Totzeit eingehalten. Die schaltenden Elemente in Vollbrücken sind häufig einfach über Kreuz angesteuert. Auch hier kann eine Totzeit vorgesehen sein.

Aus der WO 2005/094138 A ist ein Verfahren zum Betrieb einer Plasmaversorgungseinrichtung mit zumindest einer wenigstens zwei schaltende Elemente aufweisenden Schaltbrücke bekannt.

Die WO 98157406 A zeigt eine Vorrichtung zur Überwachung in einer Hochspannungs-Konverter-Station. Derartige Stationen werden in Kraftwerken als Stromrichter bei Hochspannungs-Gleichstrom-Übertragung genutzt. Sie konvertieren Gleichstrom in Wechselstrom und umgekehrt. Aus der WO 98/57406 A ist bekannt, Funktionsparameter an zugeordneten Halbleiter-Komponenten zu detektieren und Parameter der schaltenden Elemente an eine Steuereinheit zu liefern.

Auch das aus der US 2005/0219875 A1 bekannte Ansteuerverfahren berücksichtigt nicht, was an den schaltenden Elementen tatsächlich geschieht, bzw. in welchem Zustand diese schaltenden Elemente sind, um diese schützen zu können. Eine Zerstörung durch Überlast ist nach wie vor möglich. Beim bekannten Betrieb von Schaltbrücken besteht zum einen das Problem, dass beim Abschalten eines hohen Stroms in der Schaltbrücke Spannungsstöße entstehen können. Außerdem kann eine Überlast auftreten, wenn die Bodydioden der schaltenden Elemente für eine kurze Zeit auch in Sperrrichtung leiten.

Aufgabe der vorliegenden Erfindung ist es, diesbezüglich Abhilfe zu schaffen.

Gelöst wird diese Aufgabe erfindungsgemäß durch ein Verfahren mit den Merkmalen des Patentanspruchs 1.

Das erfindungsgemäße Verfahren hat den Vorteil, dass jedes schaltende Element seinen eigenen Treiber hat und separat angesteuert werden kann. Aufgrund ermittelter elektrischer und/oder sonstiger Parameter zu jedem schaltenden Element kann ein individuelles Ansteuersignal für jedes schaltende Element ermittelt werden und dieses schaltende Element entsprechend angesteuert werden, um eine Überlast an dem schaltenden Element und damit eine Zerstörung der Schaltbrücke zu vermeiden. Durch das erfindungsgemäße Verfahren kann eine Plasmaversorgungseinrichtung auch ohne absorbierende Filter vor Zerstörung der schaltenden Elemente sicher gemacht werden. Dies ist insbesondere bei Plasmaversorgungseinrichtungen wichtig und vorteilhaft, da bei Plasmalasten Fehlanpassung und chaotische Zustände häufig auftreten.

Als Betriebsparameter können elektrische Parameter, insbesondere der Strom durch das schaltende Element, die Spannung an dem schaltenden Element, der Stromverlauf oder der Spannungsverlauf ermittelt werden. Als Umgebungsparameter kann beispielsweise die Temperatur eines schaltenden Elements ermittelt werden. Als Schaltbrückenparameter kann eine mit der von der Schaltbrücke gesehenen Lastimpedanz in Beziehung stehende Größe bestimmt werden. Dabei kann vorgesehen sein, dass die Betriebsparameter für jedes schaltende Element gemessen werden. Dies bedeutet einen erhöhten Messaufwand, jedoch einen verringerten Rechenaufwand, da nicht aus Messwerten für das eine Schaltelement auf entsprechende Betriebsparameter anderer Schaltelemente geschlossen oder rückgerechnet werden muss.

Es ist auch denkbar, die Betriebsparameter nur eines oder einiger schaltender Elemente zu messen und daraus die Betriebsparameter der anderen schaltenden Elemente zu ermitteln. Diese Vorgehensweise reduziert den Messaufwand, erhöht jedoch den Rechenaufwand zur Ermittlung der Betriebsparameter der anderen schaltenden Elemente. Beispielsweise kann aus einem Messwertepaar (z. B. Amplitude und Phasenwinkel) für die für eine Schaltbrücke gesehene Lastimpedanz und der Messung von Betriebsparametern an nur einem oder zwei schaltenden Elemente auf die zeitlichen Verläufe der elektrischen Parameter an den übrigen schaltenden Elementen zurückgerechnet werden. Die Messungen können über Lichtwellenleiter erfolgen oder zumindest die Messergebnisse über Lichtwellenleiter weitergeleitet bzw. übertragen werden. Auch kann eine Messung über eine Begleitleitung erfolgen. Diesbezüglich wird auf die PCT-Anmeldungen mit den Aktenzeichen PCT/EP2008/002657 und PCT/EP2008/004650 verwiesen, deren Inhalt hiermit zum Gegenstand dieser Anmeldung gemacht wird.

Weiterhin kann vorgesehen sein, dass die Betriebsparameter der anderen schaltenden Elemente unter Berücksichtigung einer Eichmessung, einer Simulation oder repräsentativer Werte ermittelt werden. Anhand eines beschränkten Messwertesatzes, z. B. dem Messwertepaar für die Lastimpedanz oder der von einer Schaltbrücke ausgesandten Leistung und zu dieser reflektierten Leistung können Betriebsparameter für die anderen schaltenden Elemente ermittelt werden. Insbesondere kann auf die zeitlichen Verläufe der elektrischen Parameter an allen schaltenden Elementen aufgrund eines reduzierten Datensatzes geschlossen werden. Hierzu kann eine Eichmessung an den schaltenden Elementen für alle Betriebszustände durchgeführt werden. Alternativ kann eine Simulation der Schaltbrücke durchgeführt werden. Es können auch repräsentative Werte für die einzelnen schaltenden Elemente bekannt (und abgespeichert) sein und diese bei der Ermittlung der Betriebsparameter berücksichtigt werden.

Die Simulation der Schaltbrücke bzw. der schaltenden Elemente kann in Echtzeit während der Analyse der Betriebsparameter durchgeführt werden.

Weiterhin kann vorgesehen sein, dass die Ausgangsleistung zweier Schaltbrücken über einen Koppler gekoppelt wird und an zumindest drei Toren des Kopplers eine Amplitudenmessung eines am jeweiligen Tor anliegenden Signals erfolgt. Somit können mit einer geringen Anzahl von Messungen die Betriebsparameter der einzelnen schaltenden Elemente ermittelt werden. Hierzu wird auf die PCT-Anmeldung PCT/EP2008/005241 verwiesen, deren Inhalt hiermit zum Gegenstand der Anmeldung gemacht wird.

Weiterhin können die Kurvenformen der erfassten Messwerte analysiert werden, beispielsweise indem eine Fourier-Analyse durchgeführt wird. Aufgrund der Analyse kann auf die Betriebsparameter an jedem einzelnen schaltenden Element geschlossen werden. Um eine solche Analyse durchführen zu können, müssen die Messungen mit einer hohen Zeitauflösung durchgeführt werden, da nach dem Nyquist-Kriterium die Abtastfrequenz mindestens doppelt so hoch sein muss wie die höchste zu erwartende Signalfrequenz.

Die Ansteuerung eines schaltenden Elements oder einer Gruppe schaltender Elemente kann gezielt variiert werden und die daraus resultierende Änderung der Betriebsparameter, Umgebungsparameter und/oder Schaltbrückenparameter kann analysiert werden. So kann auf die an jedem schaltenden Element anliegenden elektrischen Parameter geschlossen werden. Beispielsweise kann ermittelt werden, ob eine frühere Einschaltphase mehr oder weniger Leistung am Ausgang der Schaltbrücke nach sich zieht. Außerdem kann analysiert werden, wie die Phasenlage des Ausgangssignals beeinflusst wird, wenn die Ansteuerung eines schaltenden Elements einer Schaltbrücke variiert wird. Dies ist insbesondere dann von Bedeutung, wenn mehrere Schaltbrücken über einen Koppler, beispielsweise einen Hybridkoppler gekoppelt sind. Bei diesem erfolgt die Kopplung der Signale, die von den Schaltbrücken kommen, in Abhängigkeit von der Phase.

Die Ausgangsleistung der Plasmaversorgungseinheit kann erfasst werden und auf einen Sollwert geregelt werden. Die Regelung der Ausgangsleistung kann dabei so erfolgen, dass die schaltenden Elemente in den Schaltbrücken entsprechend angesteuert werden und einer oder mehrere Werte für Strom, Spannung und Leistung für jede Schaltbrücke gemessen wird bzw. ermittelt wird und bei der Regelung der Leistung berücksichtigt wird. Insbesondere kann durch die Ansteuerung der schaltenden Elemente die Ausgangsleistung jeder einzelnen Schaltbrücke eingestellt werden, indem die schaltenden Elemente in den Schaltbrücken gezielt angesteuert werden. Zur Leistungssteuerung bzw. -regelung der Schaltbrücken kann beispielsweise das an sich bekannte Phase-Shift-Verfahren angewendet werden.

Aufgrund der erfassten Betriebsparameter, Umgebungsparameter und/oder Schaltbrückenparameter kann ein optimales Schaltschema für jedes einzelne schaltende Element ermittelt werden, so dass die Ausgangsistleistung möglichst gut der vorgegebenen Ausgangssollleistung entspricht. Die Ansteuerung der schaltenden Elemente kann dabei so erfolgen, dass eine möglichst geringe Verlustleistung in den Schaltbrücken generiert wird. Weiterhin kann die Ansteuerung der schaltenden Elemente so erfolgen, dass diese vor Überspannung, Überstrom, hohen Spannungsänderungen, hohen Stromänderungen oder Übertemperatur geschützt werden.

Dabei kann vorgesehen sein, dass ein schaltendes Element, während es eigentlich nicht leitend sein sollte, kurzzeitig eingeschaltet wird. Dadurch erfolgt ein Schutz vor Spannungsspitzen, die durch Schalten der anderen schaltenden Elemente und Induktivitäten der Schaltbrücke verursacht werden.

Bei einer Vollbrücke kann vorgesehen sein, dass die diagonal angeordneten schaltenden Elemente wechselseitig belastet werden. Beispielsweise kann das obere schaltende Element der ersten Schaltbrücke den Stromfluss zum unteren schaltenden Elemente der anderen Schaltbrücke schalten, während das untere schaltende Element der zweiten Schaltbrücke schon an war. Danach kann das untere schaltende Element der zweiten Schaltbrücke den Stromfluss einschalten, während das obere schaltende Element der ersten Schaltbrücke schon an war. Ein analoger Algorithmus kann beim Ausschalten verwendet werden. Auch können zufällige Reihenfolgen beim An- und Abschalten der schaltenden Elemente durchgeführt werden.

Aufgrund der Ermittlung der Betriebsparameter, Umgebungsparameter und/oder Schaltbrückenparameter können überlastete schaltende Elemente identifiziert werden. Solche schaltenden Elemente können dann abgeschaltet werden. Außerdem kann eine Warnung, insbesondere ein optisches oder akustisches Signal, ausgegeben werden.

Zur Schonung von schaltenden Elementen kann auch vorgesehen sein, dass ein oder mehrere schaltende Elemente für eine oder mehrere Perioden der Grundfrequenz nicht leitend gehalten werden. Diese Maßnahme kann auch angewendet werden, um die Ausgangsleistung der Schaltbrücke zu steuern.

Die Ansteuersignale können mittels eines Algorithmus ermittelt werden, wobei der Algorithmus selbstlernend oder mittels Fuzzy-Logik ausgebildet sein kann.

Zumindest ein zeitabhängiges Messsignal kann auf eine Zwischenfrequenz heruntergemischt werden. Beispielsweise kann eine komplexe Mischung in das Basisband erfolgen und eine Auswertung im Basisband durchgeführt werden. Insbesondere können zeitabhängige Signale vor der Digitalisierung auf eine Zwischenfrequenz heruntergemischt werden. Die Mischung kann im Analogen oder im Digitalen erfolgen.

In den Rahmen der Erfindung fällt außerdem eine Plasmaversorgungseinrichtung mit den Merkmalen des Patentanspruchs 8. Mit einer solchen Plasmaversorgungeinrichtung können die Vorteile, die bezüglich des Verfahrens beschrieben wurden, erreicht werden.

Dabei sind unterschiedliche Ausgestaltungen denkbar. Ein Treiber und das zugeordnete schaltende Element können in einem gemeinsamen Gehäuse angeordnet sein. Auch kann eine Halbbrücke mit den schaltenden Elementen zugeordneten Treibern in einem gemeinsamen Gehäuse angeordnet sein. Ebenso kann eine Vollbrücke mit den schaltenden Elementen zugeordneten Treibern in einem gemeinsamen Gehäuse angeordnet sein. Wenn mehrere Bauelemente in einem gemeinsamen, insbesondere geschlossenen, Gehäuse untergebracht werden, können kürzere Verbindungsleitungen verwendet werden, sodass dadurch Induktivitäten verringert werden können. Außerdem können kürzere Sicherheitsabstände realisiert werden, ohne die Gefahr von Überschlägen, weil die Gefahr einer Verschmutzung geringer ist und damit Mindestkriechstrecken kürzer realisiert werden können. Wenn die Bauelemente in einem Gehäuse vergossen werden, können noch kürzere Sicherheitsabstände realisiert werden, ohne die Gefahr von Überschlägen.

Gemäß einer Ausführungsform kann vorgesehen sein, dass ein gemeinsamer Ansteuersignalgenerator für alle schaltenden Elemente vorgesehen ist. Somit kann an zentraler Stelle eine Analyse der Betriebsparameter, Umgebungsparameter und Schaltbrückenparameter erfolgen und aufgrund dieser Parameter ein geeignetes Ansteuersignal für jedes einzelne schaltende Element zentral ermittelt werden. Dabei kann der Ansteuersignalgenerator als digitaler Baustein, insbesondere als DSP, ausgebildet sein. Wenn der Ansteuersignalgenerator als digitales Bauelement ausgebildet ist, ist es weiterhin vorteilhaft, wenn der zumindest einen Messeinrichtung ein Analog/Digital-Wandler nachgeschaltet ist, und dem Ansteuersignalgenerator digitale Signale zur Verfügung stellen zu können. Dabei kann der Analog/Digital-Wandler in den Ansteuersignalgenerator integriert sein. Eine vereinfachte Auswertung der erfassten Messsignale kann sich ergeben, wenn ein Mischer zum Heruntermischen zeitabhängiger Messsignale auf eine Zwischenfrequenz vorgesehen ist. Dieser Mischer ist vorzugsweise einem Analog/Digital-Wandler vorgeschaltet.

Zur Erzeugung einer höheren Ausgangsleistung können die Ausgänge zweier Schaltbrücken über einen Koppler gekoppelt sein. Insbesondere kann der Koppler als Hybridkoppler, Wilkinsonkoppler oder dergleichen ausgebildet sein. Auch können Umwegsleitungen vorgesehen sein, um die Phase der Ausgangssignale einzelner Schaltbrücken zu beeinflussen, so dass die Signale in einer geeigneten Phasenlage an dem Koppler ankommen und dort optimal d. h. mit geringer Verlustleistung gekoppelt werden können.

Ein Algorithmus zur Ermittlung der Ansteuersignale für die schaltenden Elemente kann als Schaltung oder Software in dem Ansteuersignalgenerator implementiert sein. Bei dieser Ausgestaltung sind eine besonders schnelle Ermittlung der Ansteuersignale und auch eine schnelle Auswertung von Messsignalen bzw. Ermittlung von Betriebsparametern ausgehend von Messsignalen nur einiger schaltender Elemente möglich.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnungen näher erläutert. Es zeigt:
- Fig. 1: eine Ausführungsform einer Schaltbrücke, bei der Betriebsparameter der schaltenden Elemente der Schaltbrücke erfasst werden;
- Fig. 2: eine Darstellung einer Schaltbrücke, bei der die Ausgangsleistung der Schaltbrücke erfasst wird;
- Fig. 3: eine Darstellung einer Schaltbrücke, bei der Messsignale auf eine Zwischenfrequenz heruntergemischt werden;
- Fig. 4: schematisch zwei Schaltbrücken, die über einen Koppler gekoppelt sind;
- Fig. 5: eine schematische Darstellung von zwei Wellenzügen;
- Fig. 6: eine weitere Darstellung zweier gekoppelter Schaltbrücken mit einer Erläuterung der daran durchgeführten Messungen;
- Fig. 7: eine Darstellung einer Schaltbrücke, wobei die Bodydioden der schaltenden Elemente eingezeichnet sind;
- Fig. 8: eine Darstellung von Einschaltzuständen der schaltenden Elemente der Schaltbrücke gemäß Figur 7 sowie die dadurch verursachten Ströme durch die Schaltbrücke für Normalbetrieb;
- Fig. 9: eine Darstellung entsprechend der Figur 8 bei Betriebsbeginn der Schaltbrücke;
- Fig. 10: eine weitere Darstellung eines Problemfalls während des Betriebs einer Schaltbrücke;
- Fig. 11: eine Darstellung einer Schaltbrücke, bei der die Treiber und schaltenden Elemente jeweils in einem eigenen Gehäuse angeordnet sind;
- Fig. 12: eine Darstellung einer Schaltbrücke, bei der jeweils eine Halbbrücke mit zugeordneten Treibern in einem Gehäuse angeordnet ist;
- Fig. 13: eine Darstellung, bei der eine gesamte Vollbrücke in einem gemeinsamen Gehäuse angeordnet ist.

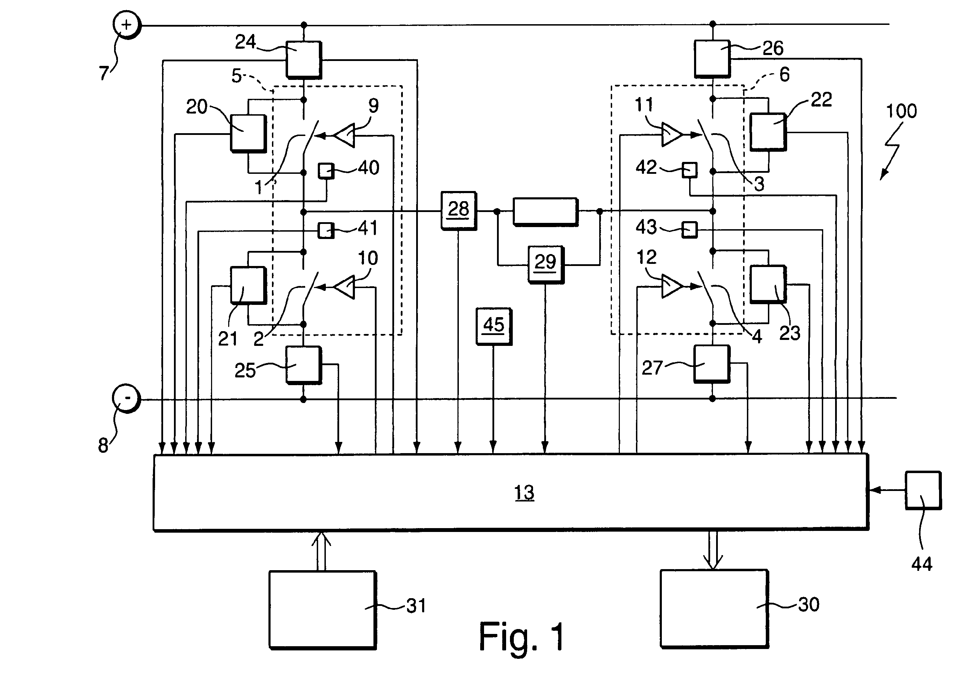

In Figur 1 ist eine als Vollbrücke ausgebildete Schaltbrücke 100 dargestellt. Die Schaltbrücke 100 weist eine erste Halbbrücke mit zwei in Serie geschalteten schaltenden Elementen 1, 2 und eine zweite Halbbrücke mit zwei in Serie geschalteten schaltenden Elementen 3, 4 auf. Jedes als Transistor ausgebildete schaltende Element 1, 2, 3, 4 wird von einem Treiber 9, 10, 11, 12 angesteuert, wobei die Treiber 9, 10, 11, 12 mit einem Ansteuersignalgenerator 13 verbunden sind, welcher Ansteuersignale an die Treiber 9, 10, 11, 12 ausgibt. Durch Einstellung der Ansteuersignale kann die Leistung am Ausgang der Schaltbrücke 100 eingestellt werden. Die Treiber 9, 10 können zusammen mit der Halbbrücke mit den schaltenden Elementen 1, 2 in einem Halbbrückenmodul 5 untergebracht sein. Gleiches gilt für die Treiber 11, 12 und die Halbbrücke bestehend aus den schaltenden Elementen 3,4 im Halbbrückenmodul 6.

Ebenso sind Temperaturmesselemente 40, 41, 42, 43 in der Nähe der schaltenden Elemente 1,2,3,4 angebracht, die ebenfalls in den Halbbrückenmodulen 5, 6 untergebracht sein können. Die Temperatur kann natürlich auch noch an weiteren Stellen erfasst werden, wie dies beispielhaft durch das Messelement 45 gezeigt ist. Die Tempraturmesselemente 40, 41, 42, 43 stehen mit dem Ansteuersignalgenerator 13 in Verbindung und liefern diesem entsprechende Messsignale.

Das obere schaltende Element 1, 3 jeder Halbbrücke ist mit dem positiven Pol 7 einer DC-Versorgungsspannung verbunden, während das untere schaltende Element 2, 4 jeder Halbbrücke an den negativen Pol 8 der DC-Versorgungsspannung angeschlossen ist.

Zur Erfassung der Betriebsparameter der schaltenden Elemente 1 bis 4 sind zur Messung der Spannung über den schaltenden Elementen 1 bis 4 Messeinrichtungen 20 bis 23 vorgesehen. Diese stehen mit dem Ansteuersignalgenerator 13 in Verbindung und liefern diesem entsprechende Messsignale. Weiterhin sind zur Strommessung der Ströme in den einzelnen schaltenden Elementen 1 bis 4 Messeinrichtungen 24 bis 27 vorgesehen, die ebenfalls ihre Messsignale an den Ansteuersignalgenerator 13 liefern. Schaltbrückenparameter, wie beispielsweise der Ausgangsstrom oder Leistung, kann durch die Messeinrichtung 28 erfasst werden. Die Ausgangsspannung als weiterer Schaltbrückenparameter kann durch die Messeinrichtung 29 erfasst werden. Auch diese Messeinrichtungen 28, 29 stehen mit dem Ansteuersignalgenerator 13 in Verbindung. Mit Hilfe der Messsignale kann der Ansteuersignalgenerator individuelle Ansteuersignale für die schaltenden Elemente 1 bis 4 generieren. Wenn eines der schaltenden Elemente zu stark belastet ist oder gar schon zerstört ist, kann beispielsweise über eine Anzeigeeinrichtung 30 eine Information an einen Betreiber gegeben werden. Externe Messwerte, die beispielsweise Informationen über das Plasma bereitstellen, können über einen Eingangspin 44, der mit dem Ansteuersignalgenerator 13 in Verbindung steht, dem Ansteuersignalgenerator 13 zugeführt und für die Erzeugung von Ansteuersignalen berücksichtigt werden.

Zur Generierung der Ansteuersignale bzw. zur Analyse der Messsignale können Daten verwendet werden, die in einem Speicher 31 abgelegt sein können und von dem Ansteuersignalgenerator 13 abgerufen werden können. Beispielsweise können Daten betreffend die einzelnen schaltenden Elemente in der Speichereinrichtung 31 abgelegt sein.

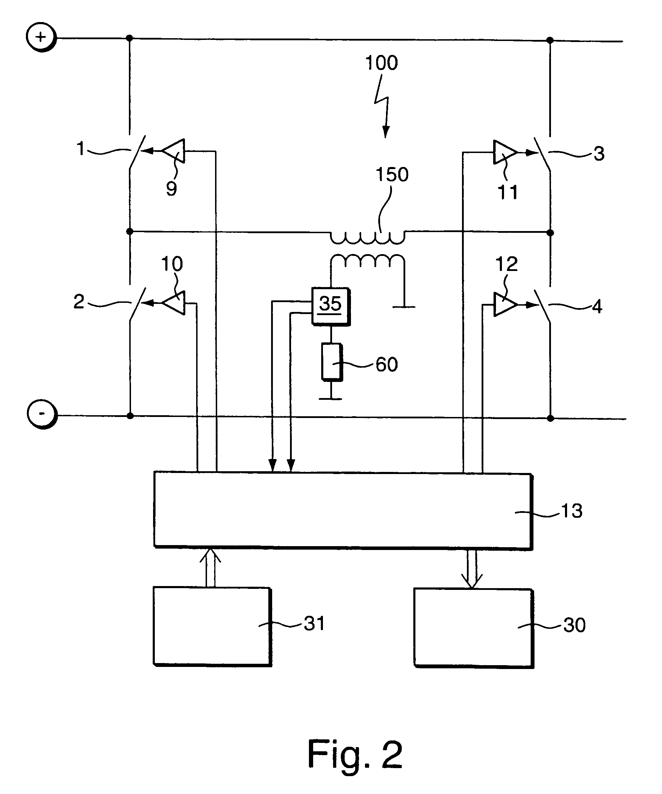

Die Figur 2 entspricht im Wesentlichen der Figur 1. Im Unterschied zu Figur 1 ist in der Figur 2 dargestellt, dass die Ausgangsleistung der Schaltbrücke 100 über einen Ausgangsübertrager 50 an eine Last 60 ausgegeben werden kann. Die in Richtung Last 60 gelieferte Leistung und die von der Last 60 bei Fehlanpassung reflektierte Leistung kann in einer Messeinrichtung 35 erfasst werden und an den Ansteuersignalgenerator 13 übergeben werden. Aufgrund dieser Messsignale, die ebenfalls Schaltbrückenparameter darstellen, kann in dem Ansteuersignalgenerator 13 auf die Betriebsparameter und Betriebszustände der einzelnen schaltenden Elemente 1 bis 4 rückgeschlossen werden. Daher kann ausgehend von diesen Informationen für jedes schaltende Element 1 bis 4 ein geeignetes Ansteuersignal generiert werden. Die Analyse der Messsignale bzw. die Rückrechnung aufgrund der Messsignale auf die Betriebsparameter bei einzelnen schaltenden Elemente 1 bis 4 kann anhand von in dem Speicher 31 abgelegten Daten erfolgen. Dort können beispielsweise Simulationsergebnisse abgelegt sein.

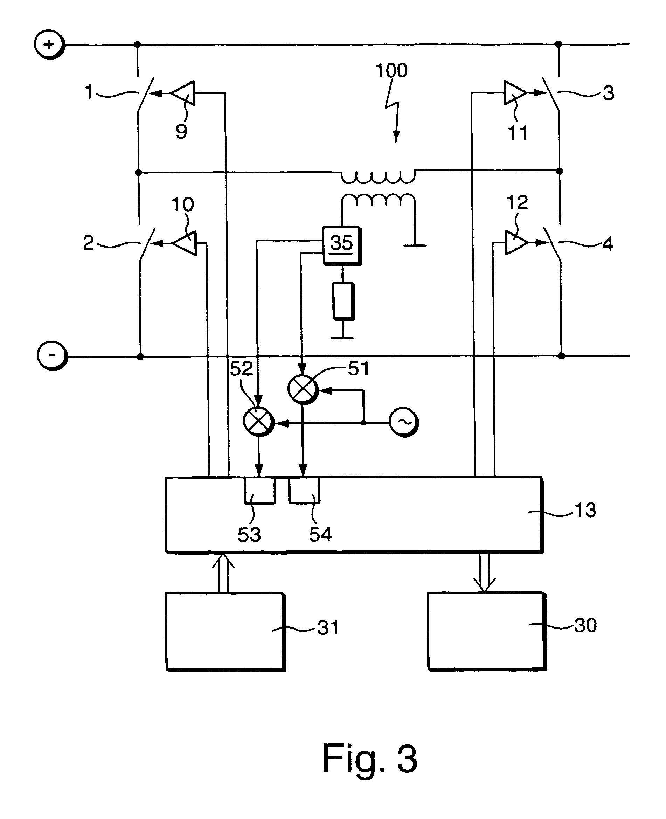

In der Figur 3 ist zusätzlich zur Figur 2 dargestellt, dass die durch die Messeinrichtung 35 gewonnenen Messsignale in Mischern 51, 52 mit einer in einem Frequenzgenerator 53 generierten Frequenz gemischt werden können und somit auf eine Zwischenfrequenz heruntergemischt werden können. Anschließend können die heruntergemischten Signale im Ansteuersignalgenerator 13 verarbeitet werden. Im Ansteuersignalgenerator können A/D-Wandler 53, 54 vorgesehen sein, durch die die analogen Signale in digitale Signale umgewandelt werden. Die weitere Verarbeitung der Signale kann dann digital erfolgen. Dazu ist es vorteilhaft, wenn der Ansteuersignalgenerator 13 als digitaler Signalprozessor ausgebildet ist.

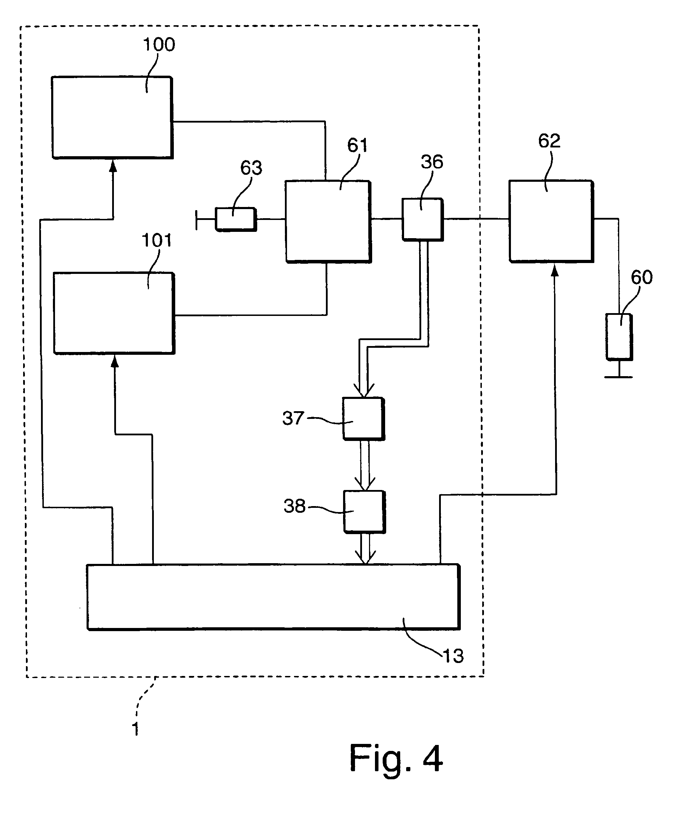

In der Figur 4 sind vereinfacht zwei Schaltbrücken 100, 101 dargestellt, deren Ausgänge über einen Koppler 61, der als Hybridkoppler ausgebildet sein kann, gekoppelt werden. Eine Ausgangsleistung des Kopplers 61 kann über ein Impedanzanpassungsnetzwerk 62 an die Plasmalast 60 transferiert werden. An das lastseitige Tor des Kopplers 61 kann als Messeinrichtung eine Auskoppelschaltung 36 angeschlossen sein, die wiederum mit einem Detektor 37 verbunden sein kann. An den Detektor 37 kann sich ein Tiefpassfilter 38 anschließen. Das dadurch erhaltene Signal wird an den Ansteuersignalgenerator 13 übergeben. Leistung, die nicht an die Last 60 geliefert wird, landet in dem Absorberwiderstand 63.

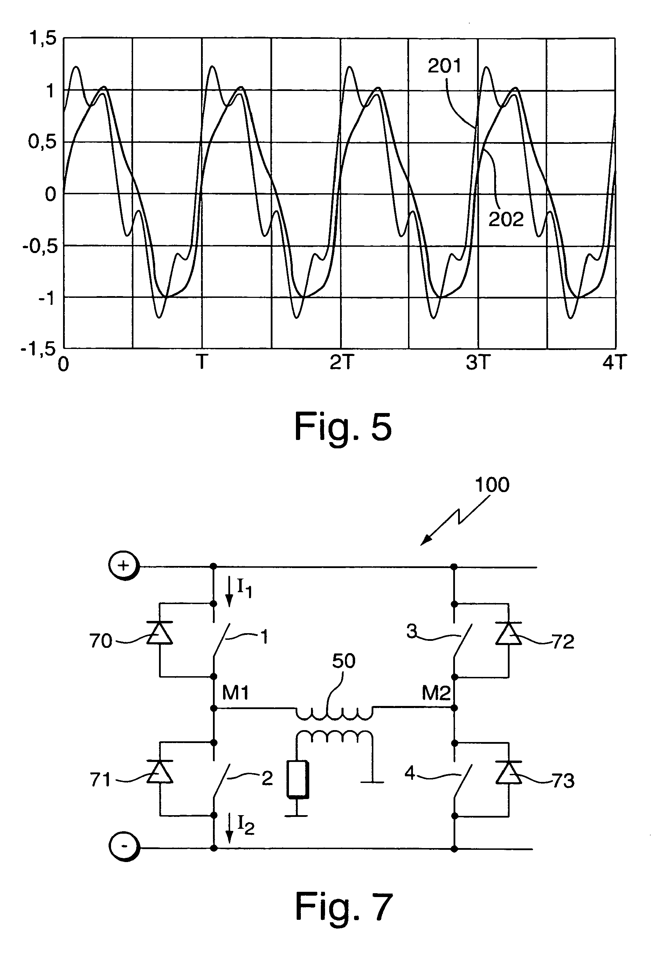

Die Figur 5 zeigt ein schematisches Beispiel von zwei Wellenzügen 201, 202 mit Oberwellen. Beispielsweise können sie den Strom und die Spannung am Ausgang einer Schaltbrücke darstellen. Aus der Analyse der Wellenzüge 201, 202 kann auf die Betriebsparameter, insbesondere die elektrischen Zustände an den schaltenden Elementen der Schaltbrücke, rückgeschlossen werden. Veränderungen der Ansteuerung eines oder mehrerer der schaltenden Elemente kann die Wellenzüge 201, 202 verändern. Aus der Veränderung können wiederum Rückschlüsse auf das Verhalten der schaltenden Elemente gezogen werden.

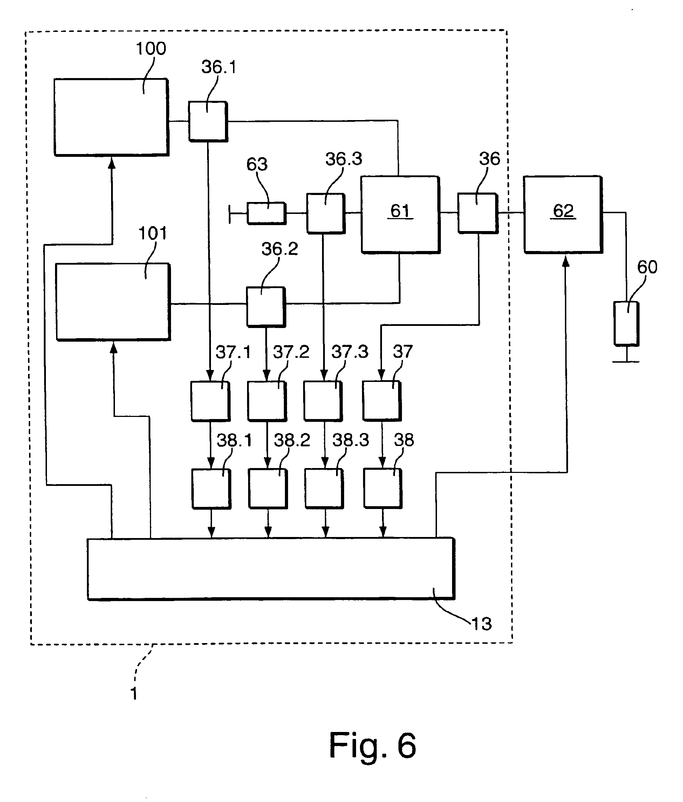

Die Figur 6 zeigt eine ähnliche Darstellung wie die Figur 4. Zusätzlich zu der Messeinrichtung 36 sind auch noch weitere Messeinrichtungen 36.1, 36.2 an den Ausgängen der Schaltbrücken 100, 101 vorgesehen. Weiterhin ist eine Messeinrichtung 36.3 vor dem Absorberwiderstand 63 vorgesehen. Durch die Messeinrichtungen 36, 36.1, 36.2, 36.3 können entweder die zeitabhängigen Signale an diesen Stellen gemessen werden oder es können auch nur die Amplituden der zeitabhängigen Signale erfasst werden und daraus weitere Parameter berechnet werden. Den Messeinrichtungen 36.1, 36.2, 36.3 sind ebenfalls Detektoren 37.1, 37.2, 37.3 und Tiefpassfilter 38.1, 38.2, 38.3 nachgeschaltet.

Figur 7 zeigt eine vereinfachte Darstellung einer Schaltbrücke 100, wobei die Bodydioden 70 bis 73 der schaltenden Elemente 1 bis 4 eingezeichnet sind. Die Mittelpunkte der Halbbrücken sind mit M1 und M2 gekennzeichnet. Weiterhin sind die Ströme 11 und 12 eingezeichnet.

Für die nachfolgenden Figuren gilt, dass die eingezeichneten Zeiten, Ströme und Einschaltzustände rein schematisch dargestellt sind und nicht maßstabsgerecht sind.

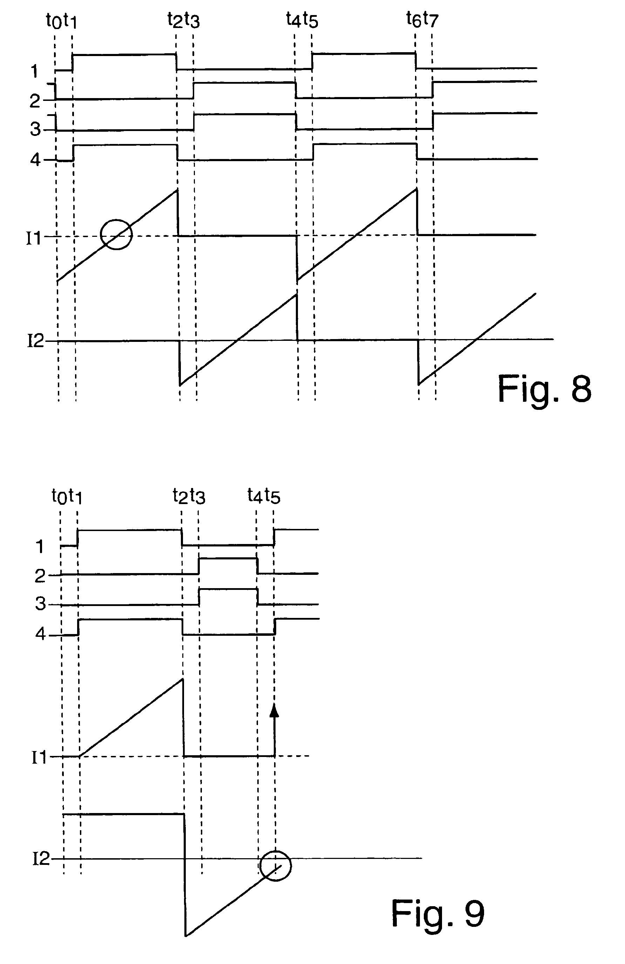

In der Figur 8 sind die Einschaltzustände der schaltenden Elemente 1 bis 4 dargestellt. Dabei entspricht ein niedriger Signalpegel dem ausgeschalteten Zustand und ein hoher Signalpegel dem eingeschalteten Zustand. Im Normalbetrieb, der in der Figur 8 dargestellt ist, schalten bei t0 die schaltenden Elemente 2 und 3 ab. Der Strom durch den Ausgangsübertrager 50, der eine parasitäre Induktivität aufweist, wird durch die Bodydioden 70, 73 der schaltenden Elemente 1 und 4 aufgefangen, bis bei t1 die schaltenden Elemente 1 und 4 einschalten. Die schaltenden Elemente 2 und 3 dürfen nicht einschalten, ehe der Strom I1 seinen Nulldurchgang hatte, da die Bodydioden 70 und 73 nach der Polung in Durchlassrichtung auch für kurze Zeit in Sperrrichtung leitend wären. Dieser Fall ist in der Figur 9 gezeigt.

In der Figur 9 werden die schaltenden Elemente 1 und 4 bei Betriebsbeginn eingeschaltet und erzeugen den Strom I1. Es ist kein (umgekehrter) Anfangsstrom, der bei einer vorherigen Stromstrecke über die schaltenden Elemente 2 und 3 und die parasitäre Induktivität erzeugt worden wäre, zu kompensieren, so dass I1 mehr als normal ansteigt. Ist die Gegenpolung zwischen den Zeitpunkten t3 und t4 dann kürzer, ist der Strom I2 beim Wiedereinschalten der schaltenden Elemente 1 und 4 noch nicht Null, so dass die Bodydioden 71, 72 (auch bei der jetzt anliegenden Sperrspannung) noch für kurze Zeit leiten und einen Kurzschluss verursachen. Der Betrieb sollte deshalb mit langsam ansteigenden Einschaltzeiten beginnen.

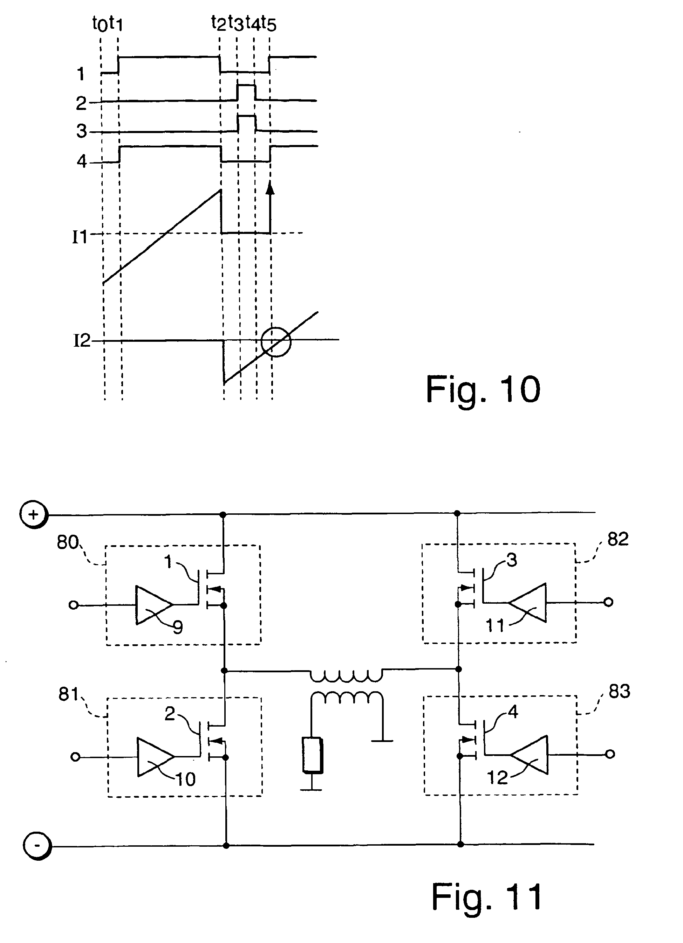

In der Figur 10 ist derselbe Problemfall geschildert, jedoch nicht nach dem Einschalten sondern während des normalen Betriebs, wenn die Schaltzeiten nicht eingehalten werden. Es kommt dadurch zu Stromspitzen.

In der Figur 11 ist dargestellt, dass jeweils ein schaltendes Element 1 bis 4 und ein Treiber 9 bis 12 in einem gemeinsamen Gehäuse 80 bis 84 angeordnet sind.

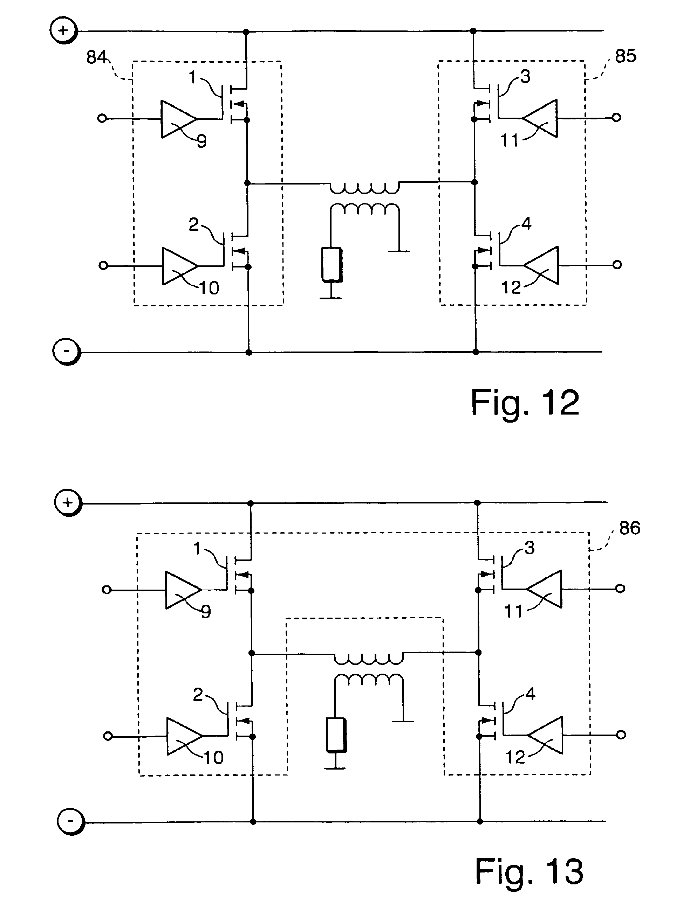

In der Figur 12 ist dargestellt, dass jeweils eine Halbbrücke, bestehend aus zwei schaltenden Elementen 1 bis 4 und zwei zugeordneten Treibern 9 bis 12, in einem eigenen Gehäuse 84, 85 angeordnet sind.

In der Figur 13 ist eine gesamte Vollbrücke, bestehend aus den schaltenden Elementen 1 bis 4 und den zugeordneten Treibern 9 bis 12, in einem gemeinsamen Gehäuse 86 angeordnet.

## Patentansprüche

1. Verfahren zum Betrieb einer Plasmaversorgungseinrichtung mit zumindest einer wenigstens zwei schaltende Elemente (1-4) aufweisenden Schaltbrücke (100, 101), wobei die Plasmaversorgungseinrichtung, ein Hochfrequenzausgangssignal mit einer Leistung > 500W und einer im Wesentlichen konstanten Grundfrequenz > 3MHz an eine Plasmalast (60) liefert, mit den Schritten
- Ermitteln zumindest eines Betriebsparameters, zumindest eines Umgebungsparameters von wenigstens einem schaltenden Element und/oder eines Schaltbrückenparameters
- Ermitteln von individuellen Ansteuersignalen für die schaltenden Elemente (1-4) unter Berücksichtigung des zumindest einen Betriebsparameters, des zumindest einen Umgebungsparameters und/oder des Schaltbrückenparameters
- Individuelles Ansteuern der schaltenden Elemente (1-4) mit jeweils einem Ansteuersignal im Normalbetrieb.

2. Verfahren nach Anspruch 1, **dadurch gekennzeichnet, dass** als Betriebsparameter elektrische Parameter, insbesondere Strom durch das schaltende Element, Spannung an dem schaltenden Element, Stromverlauf, Spannungsverlauf, ermittelt werden.

3. Verfahren nach einem der vorhergehenden Ansprüche, **dadurch gekennzeichnet, dass** als Umgebungsparameter die Temperatur des schaltenden Elements ermittelt wird.

4. Verfahren nach einem der vorhergehenden Ansprüche, **dadurch gekennzeichnet, dass** als Schaltbrückenparameter mit der von der Schaltbrücke (100, 101) gesehene Lastimpedanz in Beziehung stehende Größen bestimmt werden.

5. Verfahren nach einem der vorhergehenden Ansprüche, **dadurch gekennzeichnet, dass** die Ansteuerung eines schaltendes Elements (1-4) oder einer Gruppe schaltender Elemente (1-4) gezielt variiert wird und die daraus resultierende Änderung der Betriebsparameter, Umgebungsparameter und/oder Schaltbrückenparameter analysiert wird.

6. Verfahren nach einem der vorhergehenden Ansprüche, **dadurch gekennzeichnet, dass** ein schaltendes Element (1-4) während es eigentlich nichtleitend sein sollte, kurzzeitig eingeschaltet wird.

7. Verfahren nach einem der vorhergehenden Ansprüche, **dadurch gekennzeichnet, dass** ein oder mehrere schaltende Elemente (1-4) für eine oder mehrere Perioden der Grundfrequenz nicht leitend gehalten werden.

8. Plasmaversorgungseinrichtung zur Erzeugung einer Ausgangsleistung > 500 W bei einer im Wesentlichen konstanten Grundfrequenz > 3 MHz, die ein Hochfrequenzausgangssignal an eine Plasmalast (60) liefert, von der zumindest bei Fehlanpassung reflektierte Leistung an die Plasmaversorgungseinrichtung zurück geleitet wird, wobei die Plasmaversorgungseinrichtung zumindest einen Ansteuersignalgenerator (13) aufweist, der zumindest einen Treiber (9-12) ansteuert, wobei zumindest eine Schaltbrücke (100, 101) mit wenigstens zwei schaltenden Elementen (1-4) vorgesehen ist und jedem schaltenden Elemente (1-4) ein eigener Treiber (9-12) zugeordnet ist, wobei an die Plasmaversorgungseinrichtung eine Plasmalast (60) zumindest mittelbar angeschlossen ist, **dadurch gekennzeichnet, dass** zumindest eine mit dem Ansteuersignalgenerator (13) in Verbindung stehende Messeinrichtung (20-29, 36, 36.1, 36.2, 36.3) zur Erfassung eines Betriebsparameters zumindest eines schaltenden Elements (1-4), eines Umgebungsparameters und/oder eines Schaltbrückenparameters vorgesehen ist, wobei der Ansteuersignalgenerator (13) im Normalbetrieb individuelle Ansteuersignale für die schaltenden Elemente (1-4) generiert.

9. Plasmaversorgungseinrichtung nach Anspruch 8, **dadurch gekennzeichnet, dass** ein Treiber (9-12) und das zugeordnete schaltende Element (1-4) in einem gemeinsamen Gehäuse (80-83) angeordnet sind.

10. Plasmaversorgungseinrichtung nach einem der vorhergehenden Ansprüche, **dadurch gekennzeichnet, dass** eine Halbbrücke mit den schaltenden Elementen (1-4) zugeordneten Treibern (9-12) in einem gemeinsamen Gehäuse (84, 85) angeordnet sind.

11. Plasmaversorgungseinrichtung nach einem der vorhergehenden Ansprüche, **dadurch gekennzeichnet, dass** eine Vollbrücke mit den schaltenden Elementen (1-4) zugeordneten Treibern (9-12) in einem gemeinsamen Gehäuse (86) angeordnet sind.

12. Plasmaversorgungseinrichtung nach einem der vorhergehenden Ansprüche, **dadurch gekennzeichnet, dass** ein gemeinsamer Ansteuersignalgenerator (13) für alle schaltenden Elemente (1-4) vorgesehen ist.

13. Plasmaversorgungseinrichtung nach einem der vorhergehenden Ansprüche, **dadurch gekennzeichnet, dass** der Ansteuersignalgenerator (13) als digitales Bauelement, insbesondere als DSP ausgebildet ist.

14. Plasmaversorgungseinrichtung nach einem der vorhergehenden Ansprüche, **dadurch gekennzeichnet, dass** der zumindest einen Messeinrichtung (20-29, 36, 36.1, 36.2, 36.3) ein A/D-Wandler (53, 54) nachgeschaltet ist.

15. Plasmaversorgungseinrichtung nach einem der vorhergehenden Ansprüche, **dadurch gekennzeichnet, dass** die Ausgänge zweier Schaltbrücken (100, 101) über einen Koppler (61) gekoppelt sind.

## Claims

1. A method for the operation of a plasma supply device having at least one switching bridge (100, 101) comprising at least two switching elements (1-4), the plasma supply device delivering a high frequency output signal having a power of > 500 W and a substantially constant fundamental frequency > 3 MHz to a plasma load (60), comprising the steps:
- determining at least one operating parameter, at least one environmental parameter of at least one switching element and/or a switching bridge parameter
- determining individual drive signals for the switching elements (1-4) taking into account the at least one operating parameter, the at least one environmental parameter and/or the switching bridge parameter,
- individual driving of the switching elements (1-4) with a respective drive signal in normal operation.

2. A method according to claim 1, **characterised in that** electrical parameters, in particular the current through the switching element, the voltage at the switching element, the current path or the voltage profile are determined as operating parameters.

3. A method according to one of the preceding claims, **characterised in that** the temperature of the switching element is determined as environmental parameter.

4. A method according to any one of the preceding claims, **characterised in that** variables related to the load impedance seen by the switching bridge (100, 101) are determined as switching bridge parameters.

5. A method according to any one of the preceding claims, **characterised in that** the driving of a switching element (1-4) or a group of switching elements (1-4) is specifically varied and the resulting change in the operating parameters, environmental parameters and/or switching bridge parameters is analysed.

6. A method according to any one of the preceding claims, **characterised in that** a switching element (1-4) is switched on briefly during the time that it actually ought to be nonconductive.

7. A method according to any one of the preceding claims, **characterised in that** one or more switching elements (1-4) are maintained in a nonconductive state for one or more periods of the fundamental frequency.

8. A plasma supply device for generating an output power > 500 W at a substantially constant fundamental frequency > 3 MHz, which delivers a high-frequency output signal to a plasma load (60), by which, at least upon mismatching, reflected power is returned to the plasma supply device, wherein the plasma supply device comprises at least one drive signal generator (13), which drives at least one driver (9-12), wherein at least one switching bridge (100, 101) having at least two switching elements (1-4) is provided and each switching element (1-4) is allocated its own driver (9-12), wherein a plasma load (60) is at least indirectly connected to the plasma supply device, **characterised in that** at least one measuring device (20-29, 36, 36.1, 36.2, 36.3) for detecting an operating parameter of at least one switching element (1-4), an environmental parameter and/or a switching bridge parameter is provided, which measuring device is connected to the drive signal generator (13), wherein in normal operation the drive signal generator (13) generates individual drive signals for the switching elements (1-4).

9. A plasma supply device according to claim 8, **characterised in that** a driver (9-12) and the associated switching element (1-4) are arranged in a common housing (80-83).

10. A plasma supply device according to any one of the preceding claims, **characterised in that** a half-bridge with drivers (9-12) associated with the switching elements (1-4) is arranged in a common housing (84, 85).

11. A plasma supply device according to any one of the preceding claims, **characterised in that** a full bridge with drivers (9-12) associated with the switching Elements (1-4) is arranged in a common housing (86).

12. A plasma supply device according to any one of the preceding claims, **characterised in that** a common drive signal generator (13) is provided for all switching elements (1-4).

13. A plasma supply device according to any one of the preceding claims, **characterised in that** the drive signal generator (13) is in the form of a digital module, in particular in the form of a DSP.

14. A plasma supply device according to any one of the preceding claims, **characterised in that** an A/D converter (53, 54) is connected downstream of the at least one measuring device (20-29, 36, 36.1, 36.2, 36.3).

15. A plasma supply device according to any one of the preceding claims, **characterised in that** the outputs of two switching bridges (100, 101) are coupled by way of a coupler (61).

## Revendications

1. Procédé de fonctionnement d'un dispositif d'alimentation en plasma comportant au moins un pont de commutation (100, 101) présentant au moins deux éléments de commutation (1-4), le dispositif d'alimentation en plasma délivrant un signal de sortie à haute fréquence d'une puissance > 500 W et d'une fréquence fondamentale essentiellement constante > 3 MHz à une charge de plasma (60), lequel procédé comprend les étapes suivantes :
- détermination d'au moins un paramètre de fonctionnement, d'au moins un paramètre d'environnement d'au moins un élément de commutation et/ou d'un paramètre de pont de commutation,
- détermination de signaux d'activation individuels pour les éléments de commutation (1-4) en tenant compte dudit au moins un paramètre de fonctionnement, dudit au moins un paramètre d'environnement et/ou du paramètre de pont de commutation,
- activation individuelle des éléments de commutation (1-4) par chaque fois un signal d'activation pendant le fonctionnement normal.

2. Procédé selon la revendication 1, **caractérisé en ce que** des paramètres électriques, en particulier le courant à travers l'élément de commutation, la tension à l'élément de commutation, la courbe de courant, la courbe de tension, sont déterminés en tant que paramètres de fonctionnement.

3. Procédé selon une des revendications précédentes, **caractérisé en ce que** la température de l'élément de commutation est déterminée en tant que paramètre d'environnement.

4. Procédé selon une des revendications précédentes, **caractérisé en ce que** des grandeurs en relation avec l'impédance de charge vue par le pont de commutation (100, 101) sont déterminées en tant que paramètres de pont de commutation.

5. Procédé selon une des revendications précédentes, **caractérisé en ce que** l'on fait varier de manière ciblée l'activation d'un élément de commutation (1-4) ou d'un groupe d'éléments de commutation (1-4) et que l'on analyse la modification résultante des paramètres de fonctionnement, paramètres d'environnement et/ou paramètres de pont de commutation.

6. Procédé selon une des revendications précédentes, **caractérisé en ce qu'**un élément de commutation (1-4) est temporairement activé pendant qu'il devrait en fait être non conducteur.

7. Procédé selon une des revendications précédentes, **caractérisé en ce qu'**un ou plusieurs éléments de commutation (1-4) sont maintenus non conducteurs pendant une ou plusieurs périodes de la fréquence fondamentale.

8. Dispositif d'alimentation en plasma pour générer une puissance de sortie > 500 W à une fréquence fondamentale essentiellement constante > 3 MHz, qui délivre un signal de sortie à haute fréquence à une charge de plasma (60) par laquelle, au moins en cas de désadaptation, une puissance réfléchie est retransmise au dispositif d'alimentation en plasma, le dispositif d'alimentation en plasma présentant au moins un générateur de signaux d'activation (13) qui active au moins un circuit d'attaque (9-12), au moins un pont de commutation (100, 101) avec au moins deux éléments de commutation (1-4) étant prévu et un circuit d'attaque (9-12) distinct étant associé à chaque élément de commutation (1-4), une charge de plasma (60) étant connectée au moins indirectement au dispositif d'alimentation en plasma, **caractérisé en ce qu'**au moins un dispositif de mesure (20-29, 36, 36.1, 36.2, 36.3) relié au générateur de signaux d'activation (13), permettant de saisir un paramètre de fonctionnement d'au moins un élément de commutation (1-4), un paramètre d'environnement et/ou un paramètre de pont de commutation est prévu, le générateur de signaux d'activation (13) générant en fonctionnement normal des signaux d'activation individuels pour les éléments de commutation (1-4).

9. Dispositif d'alimentation en plasma selon la revendication 8, **caractérisé en ce qu'**un circuit d'attaque (9-12) et l'élément de commutation (1-4) associé sont disposés dans un boîtier commun (80-83).

10. Dispositif d'alimentation en plasma selon une des revendications précédentes, **caractérisé en ce qu'**un demi-pont ainsi que des circuits d'attaque (9-12) associés aux éléments de commutation (1-4) sont disposés dans un boîtier commun (84, 85).

11. Dispositif d'alimentation en plasma selon une des revendications précédentes, **caractérisé en ce qu'**un pont intégral ainsi que des circuits d'attaque (9-12) associés aux éléments de commutation (1-4) sont disposés dans un boîtier commun (86).

12. Dispositif d'alimentation en plasma selon une des revendications précédentes, **caractérisé en ce qu'**un générateur de signaux d'activation (13) commun est prévu pour tous les éléments de commutation (1-4).

13. Dispositif d'alimentation en plasma selon une des revendications précédentes, **caractérisé en ce que** le générateur de signaux d'activation (13) est réalisé sous la forme d'un composant numérique, en particulier d'un DSP.

14. Dispositif d'alimentation en plasma selon une des revendications précédentes, **caractérisé en ce qu'**un convertisseur A/N (53, 54) est placé en aval dudit au moins un dispositif de mesure (20-29, 36, 36.1, 36.2, 36.3).

15. Dispositif d'alimentation en plasma selon une des revendications précédentes, **caractérisé en ce que** les sorties de deux ponts de commutation (100, 101) sont couplées par un coupleur (61).
